# EUROPÄISCHE PATENTSCHRIFT

(11) **EP 1 468 459 B1**
(45) Veröffentlichungstag und Bekanntmachung des Hinweises auf die Patenterteilung: **10.03.2010**
(21) Anmeldenummer: 02787375.1
(22) Anmeldetag: 18.11.2002
(51) Int. Cl.: H01L 41/083, H01L 41/24, H01L 41/187

(54) **PIEZOELEKTRISCHES BAUELEMENT UND VERFAHREN ZU DESSEN HERSTELLUNG**
PIEZOELECTRIC COMPONENT AND METHOD FOR THE PRODUCTION THEREOF
COMPOSANT PIEZO-ELECTRIQUE ET SON PROCEDE DE PRODUCTION

(30) Priorität: 17.01.2002 DE 10201641
(43) Veröffentlichungstag der Anmeldung: 20.10.2004
(73) Patentinhaber: EPCOS AG, 81669 München (DE)
(72) Erfinder: FLORIAN, Heinz, A-8524 Bad Gams (AT); RAGOSSNIG (GEB. GANSBERGER), Sigrid, 9360 Friesach (AT)
(74) Vertreter: Epping, Wilhelm
(86) Internationale Anmeldenummer: PCT/DE2002/004249
(87) Internationale Veröffentlichungsnummer: WO 2003/061022

(56) Entgegenhaltungen:
- US-A- 4 978 881
- US-A- 5 614 044
- PATENT ABSTRACTS OF JAPAN vol. 2000, no. 05, 14. September 2000 (2000-09-14) & JP 2000 049396 A (KYOCERA CORP), 18. Februar 2000 (2000-02-18)
- PATENT ABSTRACTS OF JAPAN vol. 2000, no. 06, 22. September 2000 (2000-09-22) & JP 2000 077733 A (HITACHI LTD), 14. März 2000 (2000-03-14)

## Beschreibung

Die Erfindung betrifft ein piezoelektrisches Bauelement mit einem Stapel aus übereinanderliegenden piezoelektrischen Schichten und dazwischenliegenden Elektrodenschichten. Ferner betrifft die Erfindung ein Verfahren zur Herstellung des piezoelektrischen Bauelements.

Aus der Druckschrift DE 199 053 40 A1 sind piezoelektrische Bauelemente der eingangs genannten Art bekannt, die aus Keramikmaterial in Vielschichttechnik hergestellt werden. Als Keramikmaterial wird vorzugsweise PZT (Bleizirkonat-Titanat) verwendet. Die Bauteile weisen Innenelektroden auf, die nicht überall im Bauteil bis an den Rand des Stapels reichen. Dadurch entstehen sogenannte passive Zonen, bei denen sich durch Anlegen einer elektrischen Spannung zwischen den Innenelektroden lediglich ein sehr geringes elektrisches Feld aufbauen läßt. In diesen passiven Zonen ist demnach das Keramikmaterial weitgehend unpolarisiert und trägt nicht zum Hub des piezoelektrischen Bauelements bei. Daneben gibt es aktive Zonen, bei denen benachbarte Innenelektroden direkt einander gegenüber stehen, wodurch bei angelegter Spannung ein hoher piezoelektrischer Hub erzeugt werden kann. Während in der aktiven Zone des Bauelements eine Druckspannung aufgebaut wird, sind die passiven Zonen des Bauteils Zugspannungen ausgesetzt. Die Materialbelastung ist dort am größten, wo die Innenelektroden im Innern des Stapels enden, also am Übergang zwischen aktiver und passiver Zone. Am Ende der Innenelektroden kommt es zu einer Überhöhung der elektrischen Feldstärke aufgrund von Spitzeneffekten. Die Feldlinien laufen im Endbereich der Innenelektroden sternförmig zusammen und bewirken dort ein besonders hohes elektrisches Feld.

Die bekannten Bauelemente haben den Nachteil, daß in dem Bereich großer Zugspannungen in der passiven Zone leichte Risse entstehen, die bei Dauerbelastung des Bauelements entlang der Innenelektroden ins Innere des Stapels verlängert werden können. Insbesondere können die Risse entlang der Innenelektroden wachsen. Dadurch wird die Lebensdauer der Bauteile begrenzt, was einen wesentlichen Nachteil für deren Anwendung bedeutet.

Ziel der vorliegenden Erfindung ist es daher, ein piezoelektrisches Bauelement anzugeben, das eine hohe Lebensdauer aufweist.

Dieses Ziel wird durch ein erfindungsgemäßes piezoelektrisches Bauelement nach Patentanspruch 1 erreicht. Vorteilhafte Ausgestaltungen der Erfindung sowie ein Verfahren zur Herstellung des piezoelektrischen Bauelements sind den weiteren Patentansprüchen zu entnehmen.

Ein piezoelektrisches Bauelement enthält einen Stapel aus übereinanderliegenden piezoelektrischen Schichten und dazwischenliegenden Elektrodenschichten. Die Elektrodenschichten weisen im Innern des Stapels einen Mittelabschnitt sowie einen Endabschnitt auf. Der Endabschnitt ist dabei von der Innenseite einer vertikalen Randzone des Stapels begrenzt. Die Endabschnitte der Elektrodenschichten sind von einem ersten piezoelektrischen Material umgeben, dessen relative Dehnung pro angelegter elektrischer Feldstärke geringer ist als die eines zweiten piezoelektrischen Materials, das in einem Mittelbereich zwischen zwei benachbarten Elektrodenschichten angeordnet ist.

Das erste piezoelektrische Material reicht vorzugsweise in die Randzone hinein.

Durch die Reduktion der Dehnung des keramischen Materials im Bereich der Endabschnitte der Elektrodenschichten kann die mechanische Belastung in den Zonen der Endabschnitte reduziert werden. Dadurch hat die Erfindung den Vorteil, daß die Belastung der Materialien herabgesetzt und mithin die Lebensdauer des Bauelements erhöht wird. In der piezoelektrischen Schicht zwischen dem Endabschnitt einer Elektrodenschicht und der dieser Elektrodenschicht gegenüberliegenden Elektrodenschicht entsteht somit ein Gradient in der relativen Dehnung, die maximal ist in der Mitte zwischen den beiden Elektrodenschichten. Die Dehnung nimmt zu den Elektrodenschichten hin ab.

Um einen besonders vorteilhaften Effekt der Steigerung der Lebensdauer des Bauelements zu erzielen, ist es vorteilhaft, wenn die relative Dehnung des ersten piezoelektrischen Materials höchstens 95 % der relativen Dehnung des zweiten piezoelektrischen Materials beträgt.

Als Maß für die relative Dehnung der piezoelektrischen Materialien kann die piezoelektrische Kenngröße d₃₃ sowie eine weitere piezoelektrische Kenngröße d₃₁ verwendet werden. Diese Kenngrößen sind Elemente des piezoelektrischen Spannungstensors, wobei d₃₃ die Ausdehnung des piezoelektrischen Materials in Richtung eines äußeren elektrischen Feldes parallel zur Polungsrichtung beschreibt. Die zweite piezoelektrische Kenngröße d₃₁ beschreibt den Schrumpf des Materials in einer Richtung senkrecht zur Richtung dieses elektrischen Feldes. d₃₃ und d₃₁ haben entgegengesetztes Vorzeichen, wodurch die Erhaltung des Volumens der piezoelektrischen Keramik zum Ausdruck kommt.

Vorteilhaft ist desweiteren, wenn der Unterschied der relativen Ausdehnung zwischen dem ersten piezoelektrischen Material und dem zweiten piezoelektrischen Material noch größer ist. Dies ist der Fall, wenn die relative Dehnung des ersten.piezoelektrischen Materials höchstens 90 % der relativen Dehnung des zweiten piezoelektrischen Materials beträgt.

Die erhöhte Belastung des piezoelektrischen Bauelements im Bereich der Elektrodenenden ist nicht streng auf das Ende der Innenelektroden lokalisiert, sondern betrifft auch den an die Elektrodenenden angrenzenden Bereich der Innenelektroden. Es ist daher vorteilhaft, wenn die von dem ersten piezoelektrischen Material umgebene Randzone wenigstens 5 % der Fläche der Elektrodenschicht aufweist.

Um die mechanische Stabilität des Bauelements zu erhöhen, ist es vorteilhaft, wenn der Übergang zwischen dem ersten piezoelektrischen Material und dem zweiten piezoelektrischen Material hinsichtlich der relativen Dehnung graduell, das heißt stetig erfolgt. Dadurch wird eine Grenzschicht zwischen zwei unterschiedlichen piezoelektrischen Materialien vermieden, was das Auftreten von Rissen im Material zusätzlich hemmen kann.

In einer vorteilhaften Ausführungsform erhält man einen graduellen Übergang zwischen den verschiedenen piezoelektrischen Materialien, indem das erste piezoelektrische Material gebildet ist aus dem zweiten piezoelektrischen Material durch Eindiffusion eines in den Elektrodenschichten vorhandenen Dotierstoffes. Durch Diffusion des Dotierstoffes, der die relative Dehnung des ihn umgebenden piezoelektrischen Materials vermindert, kann erreicht werden, daß nicht ein scharfer sondern ein gradueller Übergang zwischen verschiedenen Eigenschaften des piezoelektrischen Materials entsteht.

In einer vorteilhaften Ausführungsform können die Elektrodenschichten Kupfer enthalten, was gleichzeitig der Dotierstoff ist, der das Ausdehnungsverhalten eines piezoelektrischen Materials verändern kann.

Das erste piezoelektrische Material kann beispielsweise Pb_{0,97} Zr_{0,54} Ti_{0,46} Nd_{0,02} O₃ mit einem Anteil von 4 - 10 Mol-% an Kupfer sein. Das zweite piezoelektrische Material kann beispielsweise das eben genannte erste piezoelektrische Material mit einem sehr geringen Anteil an Kupfer von zirka 2 Mol-% sein.

Die Erfindung kann desweiteren realisiert werden, indem das piezoelektrische Bauelement gebildet wird aus einem Stapel aus Schichten der Schichtfolge E-A-B-A-E. Dabei steht E für eine Elektrodenschicht, A für eine Keramikfolie, die das erste piezoelektrische Material enthält und B für eine Keramikfolie, die das zweite piezoelektrische Material enthält.

Dabei wäre darauf zu achten, daß der Sinterschwund der beiden piezoelektrischen Materialien aneinander angepaßt sein muß, um ein Reißen des piezoelektrischen Bauelements während des Sinterns zu verhindern. Außerdem muß darauf geachtet werden, daß die eingestellten Unterschiede in den Eigenschaften nicht durch Diffusion während der Sinterung teilweise oder ganz aufgehoben werden, das heißt, daß die Dotierstoffe eine begrenzte Mobilität aufweisen müssen.

In diesem Ausführungsbeispiel ist also der Stapel aus beispielsweise durch Siebdruck hergestellten Elektrodenschichten und durch Keramikfolien gebildeten piezoelektrischen Schichten aufgebaut.

Die Erfindung kann desweiteren realisiert werden, indem der Stapel gebildet ist aus Schichten der Schichtfolge E-C-B-C-E, wobei E für eine Elektrodenschicht, A für eine Keramikfolie, die das erste piezoelektrische Material enthält und C für eine Schicht steht, die durch zwei nebeneinanderliegende Siebdruckschichten gebildet ist. Die erste Siebdruckschicht erhält das erste piezoelektrische Material und bedeckt den Endabschnitt der benachbarten Elektrodenschicht. Die zweite Siebdruckschicht enthält das zweite piezoelektrische Material und bedeckt den Mittelabschnitt der benachbarten Elektrodenschicht von beiden Seiten.

In einer vorteilhaften Ausführungsform der Erfindung bedecken die Siebdruckschichten zusammen die Schicht B vollständig und reichen jeweils bis zum inneren Rand des Endabschnitts der Elektrodenschicht. Dadurch wird erreicht, daß der Schichtaufbau ohne Dickenvariation und ohne Lücken über den gesamten Stapel fortgesetzt werden kann.

Insbesondere ist es vorteilhaft, wenn das erfindungsgemäße Bauelement ein monolithischer Sinterkörper ist, der eine hohe mechanische Stabilität erlaubt und der einfach und billig durch Gemeinsamsintern von übereinandergestapelten Schichten hergestellten werden kann.

Es wird ferner ein Verfahren zur Herstellung eines piezoelektrischen Bauelements angegeben, wobei die Herstellung durch Sintern eines Stapels aus übereinanderliegenden Grünfolien und Elektrodenschichten erfolgt und wobei die Diffusion des Dotierstoffes von den Elektrodenschichten in das zweite Keramikmaterial während des Sinterns bei einer Temperatur zwischen 800 und 1300°C erfolgt. Beispielsweise kommt bei der Dotierung mittels Kupfer eine Temperatur zwischen 950 und 1050°C und bei der Dotierung mittels Silber/Palladium eine Sintertemperatur zwischen 1000 und 1200°C in Betracht.

Im folgenden wird die Erfindung anhand von Ausführungsbeispielen und den dazugehörigen Figuren näher erläutert.
- Figur 1: zeigt ein beispielhaftes erfindungsgemäßes piezoelektrisches Bauelement in einer perspektivischen Ansicht.
- Figur 2: zeigt einen vergrößerten Ausschnitt des Bauelements aus Figur 1 schematisch in einem Querschnitt.
- Figur 3: zeigt ein beispielhaftes Konzentrationsprofil entlang der Linie K aus Figur 2.
- Figur 3A: zeigt ein angemessenes Konzentrationsprofil entlang der Linie K aus Figur 2.
- Figur 4: zeigt verschiedene Zonen von Druckspannung und Zugspannung nach dem Beispiel aus Figur 2.
- Figur 5: zeigt beispielhaft ein weiteres erfindungsgemäßes piezoelektrisches Bauelement in einem schematischen Querschnitt.
- Figur 6: zeigt beispielhaft ein weiteres erfindungsgemäßes piezoelektrisches Bauelement in einem schematischen Querschnitt.

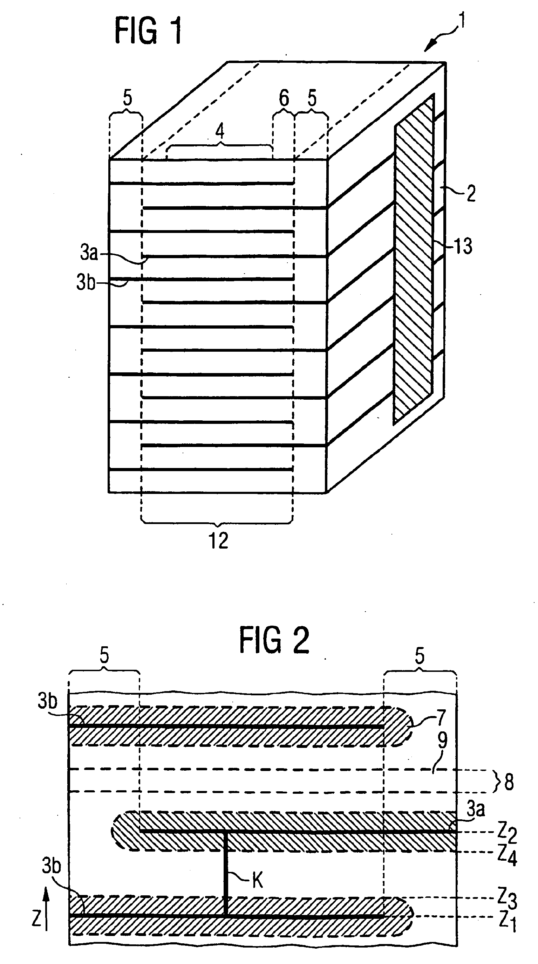

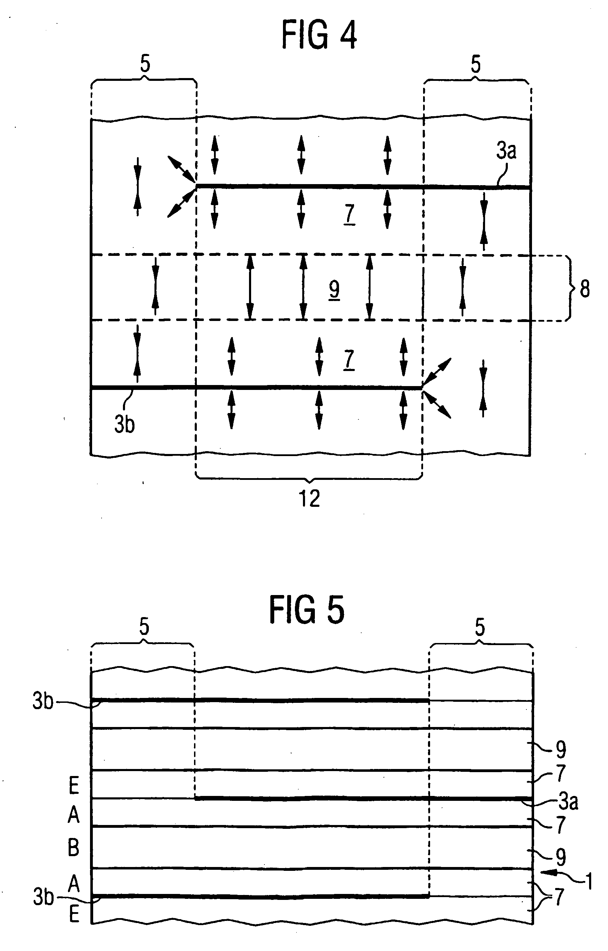

Figur 1 zeigt einen Piezoaktor mit einem Stapel 1 von übereinanderliegenden piezoelektrischen Schichten 2 und Elektrodenschichten 3a, 3b. Elektrodenschichten 3a einer ersten Sorte wechseln sich dabei mit Elektrodenschichten 3b einer zweiten Sorte ab. Die Elektrodenschichten 3a, 3b jeweils einer Sorte können durch einen außen am Stapel 1 anliegenden Metallstreifen 13 gemeinsam kontaktiert werden. Durch Anlegen von verschieden gepolten gepulsten elektrischen Spannungen an die Elektrodenschichten 3a beziehungsweise die Elektrodenschichten 3b kann erreicht werden, daß jeweils zwei einander gegenüberliegende Elektrodenschichten 3a und 3b ein elektrisches Feld an den piezoelektrischen Schichten 2 erzeugen, wodurch ein vertikaler Hub des Piezoaktors erzeugt wird. Die Elektrodenschichten 3a, 3b reichen jeweils von verschiedenen Randbereichen des Stapels 1 kommend nicht bis hin zur gegenüberliegenden Seite des Stapels 1, sondern lassen eine Randzone 5 frei. Die Randzonen 5 des Stapels 1 sind die passiven Zonen, in denen das piezoelektrische Material 2 im wesentlichen einer Zugspannung ausgesetzt ist. Dies wird auch in Figur 4 gezeigt. Der Bereich, in dem sich die Elektrodenschichten 3a, 3b direkt überlappen, ist die aktive Zone 12, in dem die piezoelektrischen Schichten im wesentlichen auf Druck belastet werden (vgl. wiederum Figur 4).

Die Abmessungen des Bauelements können beispielsweise in der Grundfläche 7 x 7 mm und in der Höhe 30 mm betragen. Dabei gelingt es, eine Anzahl von bis zu 360 Innenelektroden in das piezoelektrische Bauelement zu integrieren. Es ist auch möglich, sogenannte Bieger herzustellen, die eine Grundfläche von 20 x 6 mm sowie eine Höhe von 1,5 mm aufweisen. Solche Bieger weisen zum Beispiel 20 Innenelektroden auf.

Die Elektrodenschichten 3a beziehungsweise die Elektrodenschichten 3b können jeweils in Form von Kammstrukturen ausgebildet sein, wobei die Kammstrukturen in Form von ineinandergeschobenen Kämmen in dem fertigen Bauelement angeordnet sind. Dadurch kann ein großer mechanischer Hub des Piezoaktors erreicht werden. Die Form der Elektrodenschichten 3a, 3b selbst ist dabei beliebig, wesentlich ist lediglich, daß in einem Bereich senkrecht zur Ebene der Elektroden, der sogenannten passiven Zone, nur jede zweite Elektrode vorhanden ist.

Für die piezoelektrische Schicht 2 können die üblicherweise verwendeten PZT-Keramiken benutzt werden.

Figur 2 zeigt einen Detailausschnitt des Bauelements aus Figur 1. Die Elektrodenschichten 3a, 3b sind umgeben von einem ersten Keramikmaterial 7, das eine geringere relative Dehnung bei Anlegen einer elektrischen Spannung aufweist. Zwischen zwei benachbarten Elektrodenschichten 3a, 3b ist in einem Mittelbereich 8 ein zweites piezoelektrisches Material 9 mit einer höheren relativen Dehnung angeordnet. Das erste piezoelektrische Material 7 umgibt nicht nur den Endabschnitt der Elektrodenschichten 3a, 3b, sondern die Elektrodenschichten 3a, 3b als Ganzes. Das erste piezoelektrische Material 7 wird erzeugt aus dem zweiten piezoelektrischen Material 9 durch Eindiffundieren von in den Elektrodenschichten 3a, 3b vorhandenen Dotierstoffen. Als Dotierstoff kommt beispielsweise Kupfer in Betracht. Das Dotieren kann vorgenommen werden durch einen Temperaturschritt, der während des Sinterns des Bauelements ausgeübt wird.

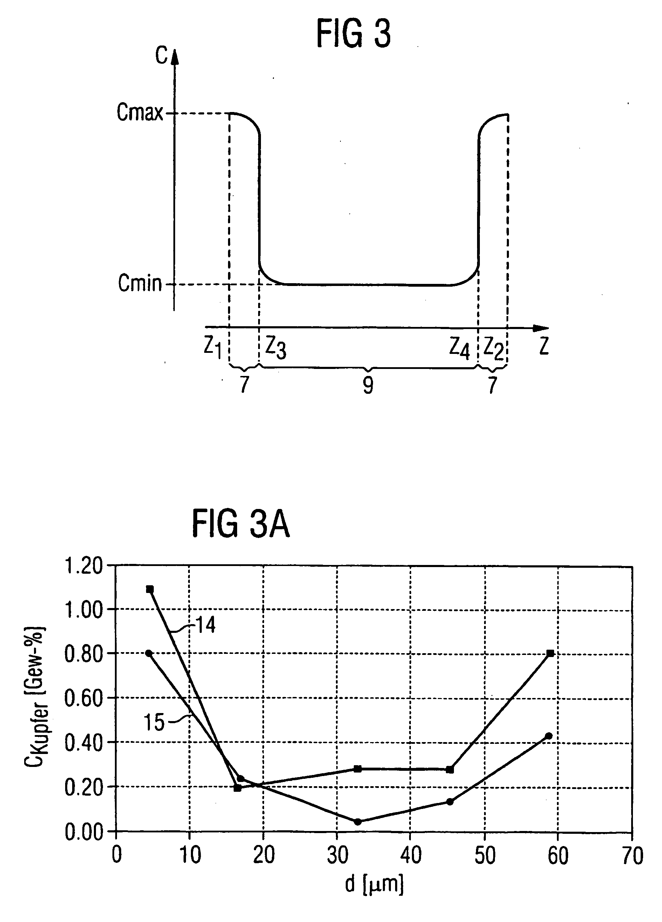

Figur 3 zeigt modellhaft die relative Konzentration c eines Dotierstoffes entlang der Linie K aus Figur 2. An den Positionen Z₁ und Z₂ sind jeweils die Elektrodenschichten 3b beziehungsweise 3a angeordnet. Zwischen den Positionen Z₁ und Z₃ besteht eine langsame abnehmende Dotierstoffkonzentration, die sich zwischen einer maximalen Dotierstoffkonzentration cₘₐₓ und einer minimalen Dotierstoffkonzentration cₘᵢₙ bewegt. In dieser Zone befindet sich das erste piezoelektrische Material 7, das eine relativ niedrige Dehnung aufweist. Die niedrige Dehnung kommt zustande durch Modifikation des zweiten piezoelektrischen Materials 9, das eine hohe Dehnung aufweist. Zwischen den Positionen Z₃ und Z₄ befindet sich eine Zone mit relativ geringer Dotierstoffkonzentration cₘᵢₙ, wobei es sich hier um das zweite piezoelektrische Material 9 mit einer hohen relativen Dehnung handelt, cₘᵢₙ kann sehr klein und gegebenenfalls auch gleich Null sein.

Figur 3 ist auch zu entnehmen, daß durch Modifikation des zweiten piezoelektrischen Materials 9 mittels Dotierung ein gradueller Übergang zwischen den verschiedenen piezoelektrischen Materialien 7, 9 geschaffen werden kann.

Die Elektrodenschichten 3a, 3b können beispielsweise in Form von Siebdruckelektroden in einem Abstand von 20 bis 200 µm ausgeführt sein. Als Dotierstoffe kommen neben Kupfer noch weitere chemische Elemente in Betracht. Insbesondere kommen in Betracht diejenigen Dotierstoffe, die zur Herstellung härterer PZT-Keramiken verwendet werden, wenn die piezoelektrischen Konstanten mit zunehmender Konzentration abnehmen.

Die Dotierstoffkonzentration c nimmt dabei ausgehend von den Elektrodenschichten 3a, 3b hin zum Mittelbereich 8 zwischen den Elektrodenschichten 3a, 3b kontinuierlich ab. Dadurch wird sichergestellt, daß sich insbesondere in der Nähe der Elektrodenschichten 3a, 3b ein piezoelektrisches Material befindet, das eine geringe relative Dehnung aufweist.

Figur 3A zeigt beispielhaft die Konzentration des Dotierstoffes Kupfer in Gew.-% entlang der Linie K aus Figur 2. Dabei ist die Kupferkonzentration C_{Kupfer} in Abhängigkeit vom Abstand d von der bei Z₂ befindlichen Innenelektrode dargestellt. Bei d = 70 µm befindet sich die zweite Innenelektrode 3b, was der Position Z₁ aus Figur 2 beziehungsweise aus Figur 3 entspricht. Es wurde dabei von der Keramik Pb_{0,97} Zr_{0,54} Ti_{0,46} Nd_{0,02} O₃ als zweitem piezoelektrischen Material ausgegangen. Die Innenelektroden 3a, 3b sind in dem Beispiel nach Figur 3A als Kupferelektroden ausgeführt. Durch Diffusion während des Sinterns bei einer Temperatur von 1000°C und einer Dauer von etwa 5 Stunden wurde das in Figur 3A durch WDX/EDX-Messung gemessene Konzentrationsprofil erreicht. Der Konzentrationsverlauf des Kupfers in dem zweiten piezoelektrischen Material entspricht qualitativ dem in Figur 3 modellhaft angegebenen Konzentrationsverlauf. Im Bereich zwischen einem Abstand d = 0 und d = 18 µm beziehungsweise in einem Bereich zwischen d = 45 und d = 70 µm wurde durch Eindiffusion des Kupfers aus den Innenelektroden 3a, 3b ein erstes piezoelektrisches Material erzeugt, das eine geringere relative Dehnung als das zweite piezoelektrische Material aufweist. Dabei beschreibt die erste Kurve 14 das Ausgangsmaterial für das zweite piezoelektrische Material wie oben angegeben und die zweite Kurve 15 als Ausgangsmaterial dasselbe Material wie oben angegeben und bei der ersten Kurve 14 dargestellt, jedoch noch mit einer zusätzlichen Kupferdotierung von ca. 1 bis 2 Mol%. Ein Mol% Cu-Konzentration entspricht dabei 0,196 Gew.-%.

Bei dem oben angegebenen Bleizirkontitanat kann eine relative Dehnung von 690 pm/V durch Dotierung mit mehr als 1 Mol% Kupfer so reduziert werden, daß eine relative Dehnung von < 650 pm/V resultiert. Die relativen Dehnungen werden dabei als Auslenkung eines vorgespannten Aktors im Vielschichtaufbau gemessen, der geeignet gepolt wurde und mit einer Feldstärke von etwa 2 KV/mm beaufschlagt wurde. Durch Erhöhung des Kupferanteils kann die relative Dehnung weiter verringert werden.

Figur 4 zeigt die Verhältnisse im unteren Bereich von Figur 2 bezüglich des Auftretens von Druck- beziehungsweise Zugspannungen bei elektrischer Belastung des Aktors und deren relative Stärke. In der aktiven Zone 12 tritt in der Hauptsache Druckspannung auf. In den mit 7 bezeichneten Zonen gilt, daß die auftretende Druckspannung relativ gering ist, aufgrund der geringen Dehnung des ersten piezoelektrischen Materials. In der mit 9 bezeichneten Zone ist die auftretende Druckspannung relativ groß, da hier das zweite piezoelektrische Material angeordnet ist. In den Randzonen 5 tritt anstelle der Druckspannung eine Zugspannung auf. Die Druckspannungen werden symbolisiert durch <-->, die Zugspannungen werden symbolisiert durch >--<. Die Länge der Doppelpfeile ist dabei lediglich ein grober Anhaltspunkt, insbesondere geht die angegebene Spannung nicht proportional mit der Länge der Pfeile.

Figur 5 zeigt ein weiteres Ausführungsbeispiel der Erfindung, wobei entsprechend auf einen Piezoaktor gemäß Figur 1 Bezug genommen wird. Im Unterschied zu Figur 2 ist gemäß Figur 5 das erste piezoelektrische Material nicht durch Diffusion eines Dotierstoffes, sondern von Haus aus durch Verwenden einer entsprechenden keramischen Grünfolie hergestellt. Figur 5 beschreibt also einen Schichtstapel der Abfolge E-A-B-A-E. Über eine Elektrodenschicht 3b wird dabei eine keramische Grünfolie, die ein erstes piezoelektrisches Material 7 enthält, gelegt. Darauf folgt eine keramische Grünfolie, die ein zweites piezoelektrisches Material 9 enthält. Es folgt wieder entsprechend der Abfolge eine Schicht A und dann eine Elektrodenschicht 3a. Die in den Keramikschichten für A und B verwendeten Keramikfolien können jeweils auf einer PZT-basierten Keramik beruhen, wobei die Einstellung der relativen Dehnung der jeweiligen Piezokeramik beziehungsweise des piezoelektrischen Materials 7, 9 entweder durch das Beifügen von einem oder mehreren Dotierstoffen oder durch Variation des Zirkon/Titan-Verhältnisses erfolgt. Es können die beiden genannten Maßnahmen auch kombiniert werden.

Die Schichtdicken der keramischen Grünfolien können dabei zwischen 20 und 200 µm betragen. Auch andere Schichtdicken sind möglich.

Die Dicke der Elektrodenschichten 3a, 3b beträgt zwischen 5 und 10 µm.

Auch in der Ausführungsform gemäß Figur 5 gilt, daß nicht nur die Endabschnitte 6 der Elektrodenschichten 3a, 3b, sondern die gesamten Elektrodenschichten 3a, 3b von einem ersten piezoelektrischen Material 7 mit niedriger relativer Dehnung umgeben sind.

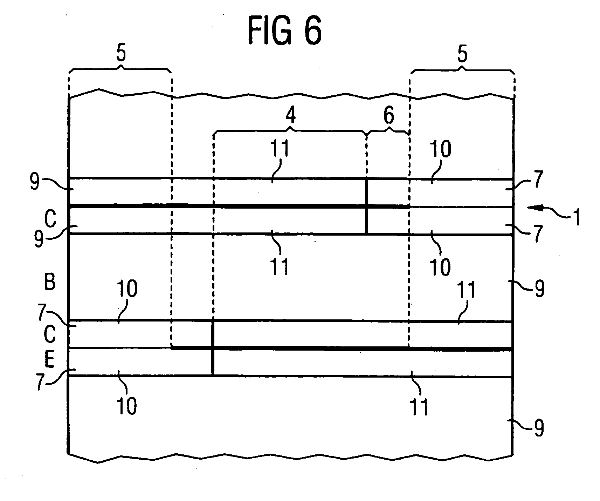

Figur 6 zeigt ein weiteres Ausführungsbeispiel der Erfindung, wobei der Aufbau des Stapels 1 entsprechend Figur 5 erfolgt, wobei jedoch in der Schichtabfolge die Schicht A durch die Schicht C ersetzt wird. Die Schicht C ist dabei nicht gebildet durch eine keramische Grünfolie, sondern sie ist zusammengesetzt aus zwei Siebdruckschichten 10, 11. Diese beiden Siebdruckschichten 10, 11 ergänzen sich zu einer über den gesamten Querschnitt des Piezoaktors durchgehenden Schicht C. Die Siebdruckschichten 10, 11 haben den Vorteil, daß sie wesentlich dünner als die keramischen Grünfolien gemäß Figur 5 ausgeführt sein können. Dadurch wird der Vorteil erzielt, daß der Gesamthub des Piezoaktors möglichst wenig beeinträchtigt wird. So ist es beispielsweise möglich, Siebdruckschichten 10, 11 mit einer Dicke von 3 bis 10 µm herzustellen. Die Siebdruckschicht 10 enthält ein erstes piezoelektrisches Material 7 mit geringer relativer Dehnung. Die Siebdruckschicht 10 bedeckt dabei jeweils auf der Oberseite und auf der Unterseite den jeweiligen Endabschnitt 6 der Elektrodenschicht 3a, 3b. Dadurch ist also der Endabschnitt 6 der Elektrodenschichten 3a, 3b von dem ersten piezoelektrischen Material 7 umgeben. Die die Siebdruckschichten 10 zu einer vollen Stapelschicht C ergänzende Siebdruckschicht 11 bedeckt jeweils den Mittelabschnitt 4 der Elektrodenschichten 3a, 3b auf der Oberseite und auf der Unterseite. Die Siebdruckschicht 11 enthält dabei das zweite piezoelektrische Material 9, das sich auch in dem Mittelbereich 8 zwischen den benachbarten Elektrodenschichten 3a, 3b befindet.

Durch den Aufbau gemäß Figur 6 wird erreicht, daß lediglich die kritischen Endabschnitte 6 der Elektrodenschichten 3a, 3b von dem ersten piezoelektrischen Material umhüllt sind. Dadurch wird der Vorteil erzielt, daß der Gesamthub des Piezoaktors möglichst wenig beeinträchtigt wird.

Bei der Erfindung ist es wesentlich, daß die Endabschnitte der Elektrodenschichten von einem piezoelektrischen Material relativ geringer Dehnung umgeben sind. Die Erfindung ist nicht beschränkt auf Ausführungen, bei denen die gesamten Elektrodenschichten von dem ersten piezoelektrischen Material umgeben sind.

### Bezugszeichenliste

- 1: Stapel
- 2: piezoelektrische Schicht
- 3a, b: Elektrodenschichten
- 4: Mittelabschnitt
- 5: Randzone
- 6: Endabschnitt
- 7, 9: piezoelektrisches Material
- 8: Mittelbereich
- 10, 11: Siebdruckschichten
- 12: aktive Zone
- 13: Metallstreifen
- Z, Z₁, Z₂, Z₃, Z₄: Z-Koordinaten
- c, cₘₐₓ, cₘᵢₙ: Dotierstoffkonzentration
- d: Abstand
- C_{Kupfer}: Kupferkonzentration
- 14: erste Kurve
- 15: zweite Kurve

## Patentansprüche

1. Piezoelektrisches Bauelement
- mit einem Stapel (1) aus übereinanderliegenden piezoelektrischen Schichten (2) und dazwischenliegenden Elektrodenschichten (3a, 3b)
- bei dem Elektrodenschichten (3a, 3b) im Innern des Stapels (1) einen Mittelabschnitt (4) sowie einen von der Innenseite einer vertikalen Randzone (5) des Stapels (1) begrenzten Endabschnitt (6) aufweisen, **gekennzeichnet dadurch, dass**
- die Endabschnitte (6) der Elektrodenschichten (3a, 3b) von einem ersten piezoelektrischen Material (7) umgeben sind, dessen relative Dehnung pro angelegter elektrischer Feldstärke geringer ist als die relative Dehnung eines zweiten piezoelektrischen Materials (9), das in einem Mittelbereich (8) zwischen zwei benachbarten Elektrodenschichten (3a, 3b) angeordnet ist.

2. Bauelement nach Anspruch 1,
bei dem die relative Dehnung des ersten piezoelektrischen Materials (7) höchstens 95 % der relativen Dehnung des zweiten piezoelektrischen Materials (9) beträgt.

3. Bauelement nach Anspruch 2,
bei dem die relative Dehnung des ersten piezoelektrischen Materials (7) höchstens 90 % der relativen Dehnung des zweiten piezoelektrischen Materials (9) beträgt.

4. Bauelement nach einem der Ansprüche 1 bis 3,
bei dem die Fläche einer Randzone (5) wenigstens 5 % der Fläche der Elektrodenschicht (3a, 3b) aufweist.

5. Bauelement nach einem der Ansprüche 1 bis 4,
bei dem der Übergang in der relativen Dehnung zwischen dem ersten und dem zweiten piezoelektrischen Material (7, 9) stetig ist.

6. Bauelement nach einem der Ansprüche 1 bis 5,
bei dem das erste piezoelektrische Material (7) gebildet ist aus dem zweiten piezoelektrischen Material (9) durch Eindiffusion eines aus den Elektrodenschichten (3a, 3b) stammenden Dotierstoffes.

7. Bauelement nach Anspruch 6,
bei dem der Dotierstoff Kupfer ist.

8. Bauelement nach Anspruch 6,
bei dem das erste piezoelektrische Material (7) Pb_{0,97} Zr_{0,56} Ti_{0,46} Nd_{0,02} O₃ mit einem Anteil von 3 - 10 Mol-% Cu und das zweite piezoelektrische Material (9) Pb_{0,97} Zr_{0,56} Ti_{0,46} Nd_{0,02} O₃ mit einem Anteil von 1 - 2 Mol-% Cu ist.

9. Bauelement nach einem der Ansprüche 1 bis 5,
- bei dem der Stapel (1) aus Schichten der Schichtfolge E-A-B-A-E gebildet ist,
- bei dem E für eine Elektrodenschicht (3a, 3b),
- bei dem A für eine Keramikfolie enthaltend das erste piezoelektrische Material (7),
- und bei dem B für eine Keramikfolie enthaltend das zweite piezoelektrische Material (9) steht.

10. Bauelement nach einem der Ansprüche 1 bis 5,
- bei dem der Stapel (1) gebildet ist aus Schichten der Schichtfolge E-C-B-C-E,
- bei dem E für eine Elektrodenschicht (3a, 3b),
- bei dem A für eine Keramikfolie enthaltend das erste piezoelektrische Material (7),
- bei dem C für eine Schicht steht, die durch zwei nebeneinanderliegende Siebdruckschichten (10, 11) gebildet ist,
- bei dem die erste Siebdruckschicht (10) das erste piezoelektrische Material (7) enthält und den Endabschnitt (6) der benachbarten Elektrodenschicht (3a, 3b) bedeckt,
- und bei dem die zweite Siebdruckschicht (11) das zweite piezoelektrische Material (9) enthält und den Mittelabschnitt (4) der benachbarten Elektrodenschicht (3a, 3b) bedeckt.

11. Bauelement nach Anspruch 10,
bei dem die Siebdruckschichten (10, 11) die Schicht B vollständig bedecken und jeweils bis zum inneren Rand des Endabschnitts (6) der benachbarten Elektrodenschicht (3a, 3b) reichen.

12. Bauelement nach einem der Ansprüche 1 bis 11,
bei dem der Stapel (1) ein monolithischer Sinterkörper ist.

13. Bauelement nach einem der Ansprüche 1 bis 12,
bei dem die Elektrodenschichten (3a, 3b) Kupfer enthalten.

14. Verfahren zur Herstellung eines piezoelektrischen Bauelements mit einem Stapel (1) aus übereinanderliegenden piezoelektrischen Schichten (2) und dazwischenliegenden Elektrodenschichten (3a, 3b), bei dem die Elektrodenschichten (3a, 3b) von einem ersten piezoelektrischen Material (7) umgeben sind, dessen relative Dehnung pro angelegter elektrischer Feldstärke geringer ist als die relative Dehnung eines zweiten piezoelektrischen Materials (9), das in einem Mittelbereich (8) zwischen zwei benachbarten Elektrodenschichten (3a, 3b) angeordnet ist,
wobei die Herstellung durch Sintern eines Stapels (1) aus übereinanderliegenden keramischen Grünfolien und Elektrodenschichten (3a, 3b) erfolgt und
wobei das erste piezoelektrische Material (7) gebildet wird aus dem zweiten piezoelektrischen Material (9) durch Eindiffundieren von in den Elektrodenschichten (3a, 3b) enthaltenen Dotierstoffen während einer Dauer von 4 bis 10 h bei einer Temperatur zwischen 800°C und 1500°C, welche während des Sinterns des Stapels (1) erreicht wird.

## Claims

1. Piezoelectric component
- comprising a stack (1) of piezoelectric layers (2) lying one above another with electrode layers (3a, 3b) lying therebetween,
- wherein electrode layers (3a, 3b) within the stack (1) have a central section (4) and also an end section (6) delimited by the inner side of a vertical edge zone (5) of the stack (1),
**characterized in that**
- the end sections (6) of the electrode layers (3a, 3b) are surrounded by a first piezoelectric material (7), the relative expansion of which per applied electric field strength is smaller than the relative expansion of a second piezoelectric material (9), which is arranged in a central region (8) between two adjacent electrode layers (3a, 3b).

2. Component according to Claim 1,
wherein the relative expansion of the first piezoelectric material (7) is at most 95% of the relative expansion of the second piezoelectric material (9).

3. Component according to Claim 2,
wherein the relative expansion of the first piezoelectric material (7) is at most 90% of the relative expansion of the second piezoelectric material (9).

4. Component according to any of Claims 1 to 3,
wherein the area of an edge zone (5) has at least 5% of the area of the electrode layer (3a, 3b).

5. Component according to any of Claims 1 to 4,
wherein the transition in the relative expansion between the first and the second piezoelectric materials (7, 9) is continuous.

6. Component according to any of Claims 1 to 5,
wherein the first piezoelectric material (7) is formed from the second piezoelectric material (9) by indiffusion of a dopant originating from the electrode layers (3a, 3b).

7. Component according to Claim 6,
wherein the dopant is copper.

8. Component according to Claim 6,
wherein the first piezoelectric material (7) is Pb_{0.97}Zr_{0.56}Ti_{0.46}Nd_{0.02}O₃ with a proportion of 3-10 mol% Cu and the second piezoelectric material (9) is Pb_{0.97}Zr_{0.56}Ti_{0.46}Nd_{0.02}O₃ with a proportion of 1-2 mol% Cu.

9. Component according to any of Claims 1 to 5,
- wherein the stack (1) is formed from layers of the layer sequence E-A-B-A-E,
- wherein E denotes an electrode layer (3a, 3b),
- wherein A denotes a ceramic film containing the first piezoelectric material (7),
- wherein B denotes a ceramic film containing the second piezoelectric material (9).

10. Component according to any of Claims 1 to 5,
- wherein the stack (1) is formed from layers of the layer sequence E-C-B-C-E,
- wherein E denotes an electrode layer (3a, 3b),
- wherein A denotes a ceramic film containing the first piezoelectric material (7),
- wherein C denotes a layer formed by two screen printing layers (10, 11) lying alongside one another,
- wherein the first screen printing layer (10) contains the first piezoelectric material (7) and covers the end section (6) of the adjacent electrode layer (3a, 3b),
- and wherein the second screen printing layer (11) contains the second piezoelectric material (9) and covers the central section (4) of the adjacent electrode layer (3a, 3b).

11. Component according to Claim 10,
wherein the screen printing layers (10, 11) completely cover the layer B and in each case extend as far as the inner edge of the end section (6) of the adjacent electrode layer (3a, 3b).

12. Component according to any of Claims 1 to 11,
wherein the stack (1) is a monolithic sintering body.

13. Component according to any of Claims 1 to 12,
wherein the electrode layers (3a, 3b) contain copper.

14. Method for producing a piezoelectric component comprising a stack (1) of piezoelectric layers (2) lying one above another with the electrode layers (3a, 3b) lying therebetween, wherein the electrode layers (3a, 3b) are surrounded by a first piezoelectric material (7), the relative expansion of which per applied electric field strength is smaller than the relative expansion of a second piezoelectric material (9), which is arranged in a central region (8) between two adjacent electrode layers (3a, 3b),
wherein production is effected by sintering a stack (1) of ceramic green sheets and electrode layers (3a, 3b) lying one above another, and
wherein the first piezoelectric material (7) is formed from the second piezoelectric material (9) by indiffusing dopants contained in the electrode layers (3a, 3b) during a duration of 4 to 10 h at a temperature of between 800°C and 1500°C which is achieved during the sintering of the stack (1).

## Revendications

1. Composant piézoélectrique
- comprenant une pile (1) de couches (2) piézoélectriques superposées et de couches (3a, 3b) d'électrode interposées entre elles,
- dans lequel des couches (3a, 3b) d'électrode à l'intérieur de la pile (1) ont une partie (4) médiane ainsi qu'une partie (6) d'extrémité délimitée par le côté intérieur d'une zone (5) de bord vertical de la pile (1), **caractérisé en ce que**
- les parties (6) d'extrémité des couches (3a, 3b) d'électrode sont entourées d'un premier matériau (7) piézoélectrique dont l'étendue relative par intensité du champ électrique appliqué est plus petite que l'étendue relative d'un deuxième matériau (9) piézoélectrique qui est disposé dans une région (8) médiane entre deux couches (3a, 3b) d'électrode voisines.

2. Composant suivant la revendication 1,
dans lequel l'étendue relative du premier matériau (7) piézoélectrique représente au plus 95% de l'étendue relative du deuxième matériau (9) piézoélectrique.

3. Composant suivant la revendication 2,
dans lequel l'étendue relative du premier matériau (7) piézoélectrique représente au plus 90% de l'étendue relative du deuxième matériau (9) piézoélectrique.

4. Composant suivant l'une des revendications 1 à 3,
dans lequel la surface d'une zone (5) de bord représente au moins 5% de la surface de la couche (3a, 3b) d'électrode.

5. Composant suivant l'une des revendications 1 à 4,
dans lequel l'étendue relative de la transition entre les premier et deuxième matériaux (7, 9) piézoélectriques est continue.

6. Composant suivant l'une des revendications 1 à 5,
dans lequel le premier matériau (7) piézoélectrique est formé à partir du deuxième matériau (9) piézoélectrique par diffusion d'une substance de dopage provenant des couches (3a, 3b) d'électrode.

7. Composant suivant la revendication 6,
dans lequel la substance de dopage est le cuivre.

8. Composant suivant la revendication 6,
dans lequel le premier matériau (7) piézoélectrique est Pb_{0,97} Zr_{0,56} Ti_{0,46} Nd_{0,02} O₃, ayant une proportion de 3 à 10% en mole de Cu et le deuxième matériau (9) piézoélectrique est de Pb_{0,97} Zro,56 Ti_{0,46} Nd_{0,02} O₃, ayant une proportion de 1 à 2 % en mole de Cu.

9. Composant suivant l'une des revendications 1 à 5,
- dans lequel la pile (1) est formée de couches selon la succession E-A-B-A-E,
- dans lequel E représente une couche (3a, 3b) d'électrode,
- dans lequel A représente une feuille de céramique contenant le premier matériau (7) piézoélectrique,
- et dans lequel B représente une feuille de céramique contenant le deuxième matériau (9) piézoélectrique.

10. Composant suivant l'une des revendications 1 à 5,
- dans lequel la pile (1) est formée de couches selon la succession E-C-B-C-E,
- dans lequel E représente une couche (3a, 3b) d'électrode,
- dans lequel A représente une feuille de céramique contenant le premier matériau (7) piézoélectrique,
- dans lequel C représente une couche qui est formée par deux couches (10, 11) de sérigraphie disposées l'une à côté de l'autre,
- dans lequel la première couche (10) de sérigraphie contient le premier matériau (7) piézoélectrique et recouvre la partie (6) d'extrémité de la couche (3a, 3b) d'électrode voisine,
- et dans lequel la deuxième couche de sérigraphie contient le deuxième matériau (9) piézoélectrique et recouvre la partie (4) médiane de la couche (3a, 3b) d'électrode voisine.

11. Composant suivant la revendication 10,
dans lequel les couches (10, 11) de sérigraphie recouvrent complètement la couche B et vont respectivement jusqu'au bord intérieur de la partie (6) d'extrémité de la couche (3a, 3b) d'électrode voisine.

12. Composant suivant l'une des revendications 1 à 11,
dans lequel la pile (1) est un corps fritté monolithique.

13. Composant suivant l'une des revendications 1 à 12,
dans lequel les couches (3a, 3b) d'électrode contiennent du cuivre.

14. Procédé de fabrication d'un composant piézoélectrique comprenant une pile (1) de couches (2) piézoélectriques superposées et de couches (3a, 3b) d'électrode interposées entre elles, dans lequel les couches (3a, 3b) d'électrode sont entourées d'un premier matériau (7) piézoélectrique dont l'étendue relative par intensité du champ électrique appliqué est plus petite que l'étendue relative d'un deuxième matériau (9) piézoélectrique qui est disposé dans une région (8) médiane entre deux couches (3a, 3b) d'électrode voisines,
dans lequel la fabrication s'effectue par frittage d'une pile (1) de feuilles de céramique crue et de couches (3a, 3b) d'électrode superposées et,
dans lequel on forme le premier matériau (7) piézoélectrique à partir du deuxième matériau (9) piézoélectrique par diffusion de substances de dopage contenues dans les couches (3a, 3b) d'électrode, pendant une durée de 4 à 10 heures, à une température comprise entre 800°C et 1500°C, qui est atteinte pendant le frittage de la pile (1).
